# FASCICULE DE BREVET EUROPEEN

(11) **EP 3 753 047 B1**
(45) Date de publication et mention de la délivrance du brevet: **05.10.2022**
(21) Numéro de dépôt: 19703400.2
(22) Date de dépôt: 14.01.2019
(51) Int. Cl.: H01L 21/762

(54) **STRUCTURE DÉMONTABLE ET PROCÉDÉ DE DÉMONTAGE UTILISANT LADITE STRUCTURE**
ENTFERNBARE STRUKTUR UND ENTFERNUNGSVERFAHREN UNTER VERWENDUNG DIESER STRUKTUR
DISMOUNTABLE STRUCTURE AND METHOD OF DISMANTLING USING SAID STRUCTURE

(30) Priorité: 13.02.2018 FR 1851179
(43) Date de publication de la demande: 23.12.2020
(73) Titulaire: SOITEC, 38190 Bernin (FR)
(72) Inventeur: LANDRU, Didier, 38190 LE CHAMP-PRES-FROGES (FR); KONONCHUK, Oleg, 38570 THEYS (FR); BEN MOHAMED, Nadia, 38130 ECHIROLLES (FR); GUERIN, Rénald, 38330 SAINT ISMIER (FR); COLOMBET, Norbert, 38420 SAINT-JEAN-LE-VIEUX (FR)
(74) Mandataire: Grünecker Patent- und Rechtsanwälte PartG mbB
(86) Numéro de dépôt international: PCT/FR2019/050065
(87) Numéro de publication internationale: WO 2019/158833

(56) Documents cités:
- FR-A1- 2 865 574
- FR-B1- 2 865 574
- US-A1- 2002 022 337
- US-A1- 2004 079 941

## Description

### DOMAINE DE L'INVENTION

La présente invention concerne le domaine du transfert de couches minces pour les applications microélectroniques, optiques, microsystèmes... Elle concerne en particulier une structure démontable pouvant être utilisée pour le transfert ou la manipulation de couches minces.

### ARRIERE PLAN TECHNOLOGIQUE DE L'INVENTION

Les substrats de silicium ou de silicium sur isolant (SOI pour « Silicon on Insulator ») sont largement utilisés pour la fabrication de dispositifs microélectroniques. Comme cela est bien connu en soi, un tel substrat comporte une couche mince de silicium et un oxyde enterré, disposés sur un substrat support. Pour permettre une intégration toujours plus importante de transistors sur ces substrats, la diminution des dimensions latérales des composants élémentaires et la finesse de gravure requièrent des substrats d'une qualité croissante, tant en terme de qualité cristalline que d'uniformité de couches.

Pour l'élaboration d'un substrat SOI présentant la qualité requise, des traitements thermiques à hautes températures sont appliqués, notamment pour réaliser la finition de la couche mince de silicium. En particulier, une étape de recuit thermique à environ 1200°C, sous atmosphère inerte peut être utilisée pour le lissage thermique de la couche mince afin d'atteindre le niveau de rugosité de surface requis, typiquement < 0,2nm RMS, tout en conservant une très bonne uniformité d'épaisseur de ladite couche mince.

Certaines applications requièrent, non seulement une haute qualité de la couche mince dans laquelle seront élaborés les composants, mais également un substrat support présentant des caractéristiques particulières. C'est par exemple le cas, dans le domaine des composants radiofréquences (RF), pour lesquels il est intéressant d'avoir un substrat support fortement résistif. Un substrat de verre peut par exemple présenter un intérêt. Alternativement, quand le substrat support est en silicium à haute résistivité, il est avantageusement muni d'une couche de piégeage des charges, de manière à limiter les pertes et distorsions du signal RF. Sur ce sujet, on pourra se référer à l'ouvrage « Silicon-on-insulator (SOI) Technology, manufacture and applications » (points 10.7 et 10.8, Oleg Kononchuk et Bich-Yen Nguyen, chez Woodhead Publishing), qui traite notamment de substrats SOI avec une couche de piégeage (« trap rich »).

Lorsque le substrat support est en matériau autre que le silicium (verre par exemple) ou qu'il est muni d'une couche de piégeage, les traitements thermiques à très haute température de finition du substrat SOI ne peuvent pas être appliqués car ils détérioreraient la structure ou la couche de piégeage.

Or, sans ces traitements, il est difficile de garantir la qualité requise de la couche mince.

Il existe plusieurs procédés de transfert sur un substrat final, d'une couche mince, élaborée sur un substrat initial et présentant, avant le transfert, la qualité finale requise. Le substrat initial comporte habituellement une couche d'oxyde enterré sur laquelle est disposée la couche mince, la couche d'oxyde étant elle-même disposée sur un substrat support, adapté pour subir les traitements de finition de la couche mince. Par ailleurs, le substrat final présente les caractéristiques requises pour une application spécifique visée.

Certains procédés de transfert consistent à assembler la couche mince finie (disposée sur le substrat initial) avec le substrat final, puis à éliminer mécaniquement et/ou chimiquement le substrat support du substrat initial, transférant ainsi ladite couche mince sur le substrat final. Les inconvénients principaux de cette approche sont les coûts liés à la perte du substrat support initial et les traitements mécaniques et chimiques contraignants susceptibles de dégrader la qualité de la couche mince au cours du transfert.

D'autres procédés sont basés sur une séparation par application d'une contrainte mécanique ou d'un traitement chimique au niveau d'une couche ou d'une interface fragilisée présente dans le substrat initial, entre la couche mince et le substrat support du substrat initial, permettant de transférer la couche mince du substrat initial vers le substrat final.

Les inconvénients de ces approches viennent essentiellement du fait que les étapes de séparation, par application d'une force mécanique à l'assemblage substrat initial - substrat final ou par immersion dans une solution chimique, sont susceptibles de dégrader la qualité de la couche mince.

Encore d'autres procédés, basés sur la séparation par laser au niveau d'une interface (« laser lift-off ») requièrent l'utilisation d'un substrat transparent (pour le substrat final ou pour le substrat support initial), ce qui limite le champ des applications.

Enfin, les documents US2002022337 A1 et FR2865574 A1 proposent un procédé de séparation de deux éléments d'une structure par implantation ionique. Ce procédé consiste à introduire des ions à l'interface des deux éléments, ces ions étant aptes à casser les liaisons interatomiques existant entre les deux éléments.

Un inconvénient de ce procédé est qu'il nécessite une dose importante et une bonne précision sur la profondeur d'implantation.

### OBJET DE L'INVENTION

La présente invention vise à pallier tout ou partie des inconvénients de l'état de la technique. Un objet de l'invention est une structure configurée pour être démontable au niveau d'une interface, et pouvant être utilisée pour le transfert ou la manipulation de couches minces.

### BREVE DESCRIPTION DE L'INVENTION

La présente invention concerne une structure démontable, selon la revendication 1, comportant un substrat support et une couche d'oxyde de silicium disposée sur ledit substrat au niveau d'une première interface. La structure démontable est remarquable en ce que :
- La couche d'oxyde présente une épaisseur inférieure à 200 nm ;
- Des espèces légères d'hydrogène et/ou d'hélium sont réparties en profondeur et sur toute l'étendue de la structure selon un profil d'implantation dont le maximum de concentration est situé dans l'épaisseur de la couche d'oxyde ;
- La dose totale d'espèces légères implantées, ramenée à l'épaisseur de la couche d'oxyde, excède au moins d'un facteur cinq la limite de solubilité de ces espèces légères dans ladite couche d'oxyde.

Selon des caractéristiques avantageuses de l'invention, prises seules ou en combinaison :
- la structure démontable comprend une couche mince adaptée pour la fabrication de composants et/ou une couche mince formant une couche barrière, disposée sur la couche d'oxyde au niveau d'une deuxième interface ;
- le substrat support est en silicium et la couche d'oxyde de silicium est un oxyde thermique ;
- la couche mince est en silicium monocristallin ;
- la couche mince est en nitrure de silicium.

L'invention concerne également un procédé, selon la revendication 6, de démontage de la structure démontable selon la revendication 2, telle que ci-dessus, comprenant :
a) L'assemblage de la structure démontable et d'un deuxième substrat le long d'une interface de collage ;
b) L'application d'un traitement thermique à l'assemblage pour faire migrer au moins une partie des espèces légères au niveau de la première ou de la deuxième interface ;
c) Le détachement spontané de l'assemblage au niveau de la première interface ou de la deuxième interface, formant une surface démontée de la couche d'oxyde et menant au transfert d'au moins la couche mince sur le deuxième substrat pour former une structure composite.

Selon des caractéristiques avantageuses de l'invention, prises seules ou en combinaison :
- l'étape b) est effectuée à une température comprise entre 200°C et 600°C ;
- l'étape c) s'effectue au cours du traitement thermique de l'étape b) ;
- la rugosité de la surface démontée de couche d'oxyde est inférieure à 0,5nm RMS ;
- la structure démontable fournie à l'étape a), comprend une couche mince adaptée pour la fabrication de composants, disposée sur la couche d'oxyde au niveau de la deuxième interface, et les espèces légères d'hydrogène et/ou d'hélium ont été implantées dans l'épaisseur de la couche d'oxyde après une étape de finition de la couche mince ;
- l'étape de finition de la couche mince comprend un traitement thermique à haute température, en particulier supérieure à 1000°C, voire supérieure à 1100°C ;
- le deuxième substrat fourni à l'étape a) comprend un deuxième substrat support, une couche de piégeage disposée sur le deuxième substrat support et une deuxième couche d'oxyde de silicium disposée sur la couche de piégeage, la deuxième couche d'oxyde de silicium étant destinée à être assemblée sur le substrat démontable au niveau de l'interface de collage ;
- le deuxième substrat fourni à l'étape a) comprend un substrat en verre ;
- le deuxième substrat fourni à l'étape a) comprend un deuxième substrat support et une deuxième couche d'oxyde de silicium disposée sur le deuxième substrat support et présentant une épaisseur supérieure à 800nm, la deuxième couche d'oxyde de silicium étant destinée à être assemblée sur le substrat démontable au niveau de l'interface de collage.
- le procédé de démontage comprend, après l'étape c), une étape de traitement thermique de la structure composite à une température inférieure à 1000°C, pour évacuer les espèces légères encore présentes dans la couche mince transférée.

### BREVE DESCRIPTION DES DESSINS

D'autres caractéristiques et avantages de l'invention ressortiront de la description détaillée qui va suivre en référence aux figures annexées sur lesquelles :
- la figure 1 présente une structure démontable selon un premier mode de réalisation de l'invention ;
- les figures 2a et 2b présentent des structures démontables respectivement selon un deuxième et un troisième mode de réalisation de l'invention ;
- les figures 3a, 3b et 3c présentent un procédé de fabrication d'une structure démontable selon le deuxième mode de réalisation de l'invention ;
- les figures 4a, 4a', 4b et 4c présentent un procédé de démontage selon une première variante de mise en œuvre d'une structure démontable conforme à l'invention ;
- les figures 5a, 5b et 5c présentent un procédé de démontage selon une deuxième variante de mise en œuvre d'une structure démontable conforme à l'invention ;
- la figure 6 présente un exemple de structure composite obtenue après démontage d'une structure démontable selon le deuxième mode de réalisation de l'invention.

### DESCRIPTION DETAILLEE DE L'INVENTION

Dans la partie descriptive, les mêmes références sur les figures pourront être utilisées pour des éléments de même nature.

Les figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y.

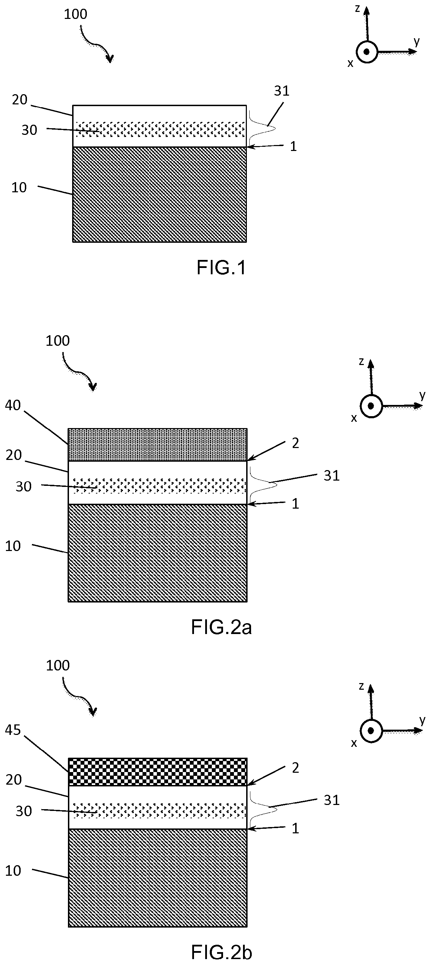

L'invention concerne une structure démontable 100 comportant un substrat support 10 et une couche d'oxyde de silicium 20 disposée sur ledit substrat au niveau d'une première interface 1 (figure 1).

Le substrat support 10 peut être choisi parmi des matériaux compatibles avec les procédés de fabrication microélectroniques ; avantageusement, il est formé en silicium, matériau classiquement utilisé dans l'industrie des semi-conducteurs. Le substrat support 10 peut se présenter sous forme de plaquette de diamètre 100 à 450mm et d'épaisseur comprise entre 250 et 850 microns par exemple.

La couche d'oxyde de silicium 20 est avantageusement issue d'une croissance thermique, lorsque le substrat support 10 est choisi en silicium. L'oxydation thermique peut être réalisée à une température entre 850°C et 1100°C, sous atmosphère oxydante sèche ou humide. Alternativement, elle peut être élaborée sur le substrat support 10 par une technique de dépôt en phase vapeur (PECVD, LPCVD...) ou en phase liquide.

Dans la structure démontable 100 selon l'invention, la couche d'oxyde 20 présente une épaisseur inférieure à 200 nm, voire inférieure à 100 nm ; avantageusement l'épaisseur de la couche d'oxyde 20 est comprise entre 10nm et 50nm.

Nous verrons par la suite comment cette restriction sur l'épaisseur de la couche d'oxyde 20 procure une bonne efficacité de démontage de la structure 100.

La structure démontable 100 comprend en outre des espèces légères 30 d'hydrogène et/ou d'hélium, réparties en profondeur, selon un profil d'implantation 31, dans la couche d'oxyde 20 : le profil d'implantation 31 est illustré sur la figure 1, il s'étend selon l'axe z. Les espèces légères 30 sont présentes sur toute l'étendue de la structure 100 dans le plan (x,y).

Elles sont avantageusement introduites dans la couche d'oxyde 20 par implantation ionique. Alternativement, et en particulier lorsque les espèces légères doivent être introduites à une faible profondeur, elles pourront être implantées par immersion plasma.

Dans la structure démontable 100 selon l'invention, on pourra implanter de l'hydrogène seul, de l'hélium seul ou encore co-implanter de l'hydrogène et de l'hélium.

Le maximum de concentration du profil 31 est situé dans l'épaisseur de la couche d'oxyde 20, avantageusement proche de la partie médiane de ladite épaisseur.

Après implantation, la dose totale implantée se retrouve, préférentiellement, en majorité à l'intérieur de la couche d'oxyde 20.

Selon l'invention, la dose totale d'espèces légères 30 implantées, ramenée à l'épaisseur de la couche d'oxyde 20, excède au moins d'un facteur cinq la limite de solubilité de ces espèces légères 30 dans ladite couche d'oxyde 20. Avantageusement, la dose totale d'espèces légères 30 implantées, ramenée à l'épaisseur de la couche d'oxyde 20, excède d'un facteur cinq à vingt ladite limite de solubilité. Rappelons que la limite de solubilité de l'hydrogène dans un oxyde de silicium est 1,5^{E}21/cm³.

Selon un premier mode de réalisation, la structure démontable 100 comprend donc le substrat support 10, la couche d'oxyde 20 de silicium et les espèces légères 30 réparties selon un profil d'implantation 31 dans la couche d'oxyde 20.

A titre d'exemple, pour une couche d'oxyde 20 présentant une épaisseur de 50nm, on pourra implanter des ions d'hydrogène à une énergie de 1keV à une dose de l'ordre de 4^{E}16/cm². La dose totale implantée (4^{E}16/cm²), ramenée à l'épaisseur de la couche d'oxyde 20 donne une concentration en hydrogène de 8^{e}21/cm³, soit un peu plus de cinq fois la limite de solubilité de l'hydrogène dans la couche d'oxyde 20 de silicium.

Typiquement, pour une couche d'oxyde 20 présentant une épaisseur allant de quelques nm à 100nm, une énergie d'implantation allant de quelques centaines d'eV à environ 10 keV et une dose allant d'environ 1^{E}16 à 7,5^{E}16/cm² pourront être utilisées pour l'implantation d'hydrogène. Avantageusement, pour une couche d'oxyde 20 présentant une épaisseur entre 10nm et 50nm, une dose d'implantation d'hydrogène sera choisie entre 1^{E}16 à 4^{E}16/cm².

La structure démontable 100 présente ainsi la faculté d'être démontable au niveau de la première interface 1, lorsqu'elle est soumise à un traitement thermique dont la température est typiquement comprise entre 200° et 600°C.

Après traitement thermique, la dose totale d'espèces légères 30 implantées va se retrouver en grande majorité à l'intérieur de la couche d'oxyde 20 (soit du fait de l'implantation directe dans la couche d'oxyde 20, soit du fait de la migration des espèces 30 dans ladite couche 20). La concentration en espèces légères 30 dépasse alors la limite de solubilité de cette même espèce dans la couche d'oxyde 20, d'un facteur cinq à vingt.

La couche d'oxyde 20 étant de faible épaisseur et la concentration des espèces légères 30 étant bien au-delà de la solubilité limite desdites espèces 30 dans la couche d'oxyde 20, les espèces légères ne pourront pas être absorbées par la couche d'oxyde 20 et une partie des espèces légères va efficacement migrer vers la première interface 1.

Cette première interface 1 étant avantageusement une interface thermique (c'est-à-dire issue de la croissance d'une couche d'oxyde thermique sur le substrat support en silicium), il a été montré expérimentalement que les espèces légères 30 migrent préférentiellement à cette interface, et, qu'au-delà d'une certaine concentration, une décohésion de l'interface se produit spontanément sous l'effet de la pression des espèces légères 30. Comme nous le verrons plus en détail dans le procédé de démontage, la structure démontable 100 peut ainsi donner lieu à un détachement entre la couche d'oxyde 20 et le substrat support 10, le long de la première interface 1.

Selon un deuxième mode de réalisation, la structure démontable 100 comprend en outre une couche mince 40 adaptée pour la fabrication de composants, disposée sur la couche d'oxyde 20 au niveau d'une deuxième interface 2 (figure 2a).

Dans ce deuxième mode de réalisation, les espèces légères 30 sont introduites dans la couche d'oxyde 20 après l'élaboration de la couche mince 40 adaptée à la fabrication de composants.

Par « adaptée à la fabrication de composants », on entend présentant la qualité et les caractéristiques structurelles requises pour la fabrication subséquente des composants visés. En particulier, la couche mince 40 présente la qualité requise en terme d'uniformité d'épaisseur, de qualité cristalline et de qualité de surface (rugosité, défectivité et contaminations résiduelles). Cela suppose donc que la couche mince 40, disposée sur la couche d'oxyde 20, elle-même disposée sur le substrat support 10 a pu subir des traitements thermiques de finition à haute température. En particulier, une étape de recuit thermique à environ 1200°C, sous atmosphère inerte peut être utilisée pour le lissage thermique de la couche mince 40 afin d'atteindre le niveau de rugosité de surface requis, typiquement < 0,2nm RMS, tout en conservant une très bonne uniformité d'épaisseur de ladite couche mince. Notons que pendant ces traitements, les espèces légères 30 ne sont pas encore présentes dans la structure démontable 100, pour éviter tout détachement intempestif.

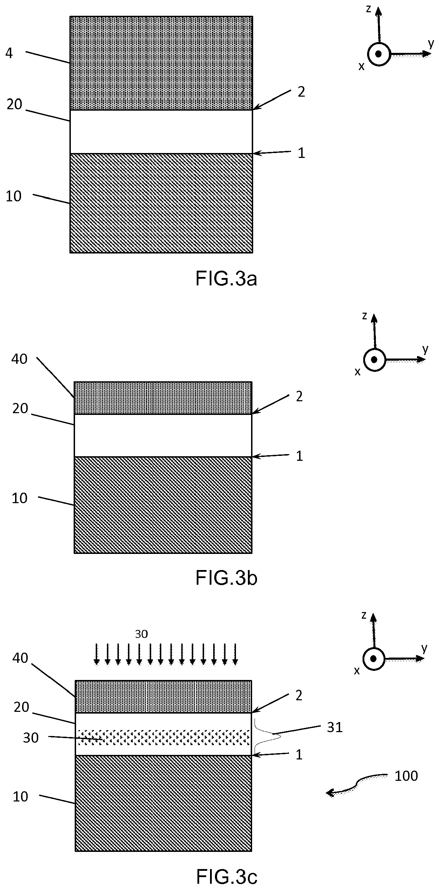

La couche mince 40 peut être élaborée de différentes manières. En général, la couche mince 40 est issue d'un substrat donneur 4 (figure 3a), assemblé à la couche d'oxyde 20 au niveau de la deuxième interface 2. Notons qu'alternativement, la couche d'oxyde 20 peut être présente sur le substrat donneur 4 (au niveau de la deuxième interface 2) et assemblée au substrat support 10 (au niveau de la première interface 1).

L'assemblage peut être réalisé par toute technique de collage, compatible avec les traitements à haute température visés pour la finition de la couche mince 40. En particulier, l'assemblage est réalisé par collage par adhésion moléculaire, technique bien connu de l'état de l'art. Préalablement au collage, les surfaces à assembler peuvent subir des traitements secs (activation plasma, par exemple) et/ou humides (nettoyage chimiques) pour améliorer la qualité et la tenue de l'interface. La deuxième interface 2 est avantageusement consolidée par l'application d'un traitement thermique.

Le substrat donneur 4 subit ensuite une étape d'amincissement, à l'issue de laquelle la couche mince 40 sera formée (figure 3b). Cette étape d'amincissement peut être faite à partir des différentes techniques connues de l'art antérieur, notamment :
- le procédé Smart-Cut^{®}, particulièrement adapté à la formation de couches très fines (typiquement d'épaisseur comprise entre quelques nanomètres et 1 micron) : il est basé sur une implantation d'espèces gazeuses dans le substrat donneur 4, au niveau de sa face assemblée, préalablement à l'étape d'assemblage, pour former un plan enterré fragilisé ; après assemblage, au cours d'une étape de fracture, le substrat donneur 4 se sépare le long du plan fragilisé, pour ne laisser solidaire du substrat support 10 que la couche mince 40.
- les procédés d'amincissement mécano-chimiques, incluant le rodage mécanique, le polissage mécano-chimique et la gravure chimique, surtout adaptés à la formation de couches d'épaisseurs comprises entre quelques microns et quelques dizaines, voire centaines de microns.

Bien-sur, les techniques énoncées ci-dessus ne sont pas exhaustives et d'autres techniques connues peuvent être utilisées pour l'amincissement du substrat donneur 4.

En vu de la fabrication de la couche mince 40, l'étape d'amincissement comprend en outre une ou plusieurs étapes de finition, aptes à restaurer la qualité en surface et en volume de la couche mince 40, comme précédemment évoqué.

Les exigences en terme de finition sont d'autant plus fortes que la couche mince 40 présente une épaisseur faible, en particulier inférieure à 200nm, voire inférieure à 100nm, voire encore inférieure à 50nm. C'est en particulier pour les couches minces 40 dans ces gammes d'épaisseurs que le substrat démontable 100 selon l'invention présente le plus fort intérêt.

Lorsque la couche mince 40 est réalisée et présente les caractéristiques requises pour l'application visée, les espèces légères 30 sont introduites selon le profil d'implantation 31 dans la couche d'oxyde 20 (figure 3c).

A titre d'exemple, dans le cas d'une couche mince 40 en silicium présentant une épaisseur de 200nm et d'une couche d'oxyde de silicium 20 présentant une épaisseur de 25nm, on pourra implanter des ions d'hydrogène à une énergie de 18keV à une dose de 4^{E}16/cm². La dose totale implantée (4^{E}16/cm²), ramenée à l'épaisseur de la couche d'oxyde 20 donne une concentration en hydrogène de 1,6^{E}22/cm³, soit environ dix fois la limite de solubilité de l'hydrogène dans la couche d'oxyde 20 de silicium.

Typiquement, pour une couche mince 40 en silicium présentant une épaisseur allant de quelques nm à 200nm et une couche d'oxyde 20 présentant une épaisseur allant de quelques nm à 100nm, une dose allant d'environ 1^{E}16 à 7,5^{E}16/cm² pourra être utilisée pour l'implantation d'hydrogène. Avantageusement, pour une couche d'oxyde 20 présentant une épaisseur entre 10nm et 50nm, la dose d'implantation d'hydrogène sera choisie entre 1^{E}16 à 4^{E}16/cm².

La structure démontable 100 présente ainsi la faculté d'être démontable au niveau de la première interface 1 ou de la deuxième interface 2, lorsqu'elle est soumise à un traitement thermique, comme expliqué dans le cadre du premier mode de réalisation.

Notons que, dans le cas d'une couche mince 40 en silicium présentant une épaisseur de 200nm et d'une couche d'oxyde de silicium 20 présentant une épaisseur de 50nm, la demanderesse a montré qu'une co-implantation d'ions d'hydrogène et d'hélium, en plaçant le maximum des profils d'implantation dans la couche d'oxyde 20, à des doses respectives de l'ordre de 1^{E}16/cm² et 1^{E}16/cm², procurait également à la structure 100 la faculté d'être démontable au niveau de la première interface 1 ou de la deuxième interface 2, lorsqu'elle est soumise à un traitement thermique. La dose totale implantée d'hydrogène (1^{E}16/cm²), ramenée à l'épaisseur de la couche d'oxyde 20 donne une concentration en hydrogène de 2^{E}21/cm³, soit seulement environ 1,3 fois la limite de solubilité de l'hydrogène dans la couche d'oxyde 20 de silicium ; la présence d'hélium permet donc de réduire le facteur de concentration requis de l'hydrogène.

Avantageusement, selon le deuxième mode de réalisation de l'invention, lorsque l'une des première 1 et deuxième 2 interfaces est issue d'une croissance thermique d'oxyde de silicium sur le substrat support 10 (première interface 1) ou sur le substrat donneur 4 (deuxième interface 2), le démontage s'opère préférentiellement à cette interface. En effet, la demanderesse a pu constater que l'interface thermique oxyde/silicium devenait plus fragile que l'interface de collage après que la structure démontable 100 ait été exposée à des températures supérieures à 900°C (ce qui est le cas, après les traitements de finition de la couche mince 40). La migration et l'accumulation des espèces légères 30 se fait donc préférentiellement à celle de la première 1 ou de la deuxième 2 interface qui est une interface thermique.

Selon un troisième mode de réalisation, la structure démontable 100 comprend le substrat support 10, la couche d'oxyde 20 et les espèces légères 30 réparties selon un profil d'implantation 31 dans ladite couche d'oxyde 20, et une couche mince 45 formant une couche barrière, disposée sur la couche d'oxyde 20 au niveau d'une deuxième interface 2 (figure 2b).

La couche barrière 45 a pour rôle de limiter, voire d'empêcher la diffusion des espèces légères 30 et donc de favoriser leur concentration dans la couche d'oxyde 20, notamment au cours du traitement thermique visant le démontage de la structure 100.

La couche mince barrière 45 pourra par exemple consister en du nitrure de silicium, du nitrure d'aluminium, de l'alumine ou autre semi-conducteur cristallin (Si, Ge, SiC), directement déposé sur la couche d'oxyde 20.

Dans ce troisième mode de réalisation, les espèces légères 30 sont avantageusement introduites dans la couche d'oxyde 20 après l'élaboration de la couche barrière 45, pour limiter l'application d'un traitement thermique à la structure démontable, avant l'étape de démontage et éviter tout détachement intempestif.

A titre d'exemple, dans le cas d'une couche mince 40 en nitrure de silicium présentant une épaisseur de 30nm et d'une couche d'oxyde de silicium 20 présentant une épaisseur de 30nm, on pourra implanter des ions d'hydrogène à une énergie de 2keV à une dose de l'ordre de 3^{E}16/cm². La dose totale implantée (3^{E}16/cm²), ramenée à l'épaisseur de la couche d'oxyde 20 donne une concentration en hydrogène de 1^{E}22/cm³, soit environ sept fois la limite de solubilité de l'hydrogène dans la couche d'oxyde 20 de silicium.

La couche mince barrière 45 permet de maintenir le confinement et la saturation des espèces légères dans la couche d'oxyde 20: cela favorise la migration des dites espèces 30 vers la première 1 ou la deuxième 1 interface.

La structure démontable 100 présente ainsi la faculté d'être démontable au niveau de la première interface 1 ou de la deuxième interface 2, lorsqu'elle est soumise à un traitement thermique, comme expliqué précédemment.

La structure démontable 100 selon ce troisième mode de réalisation peut être utilisée en tant que support temporaire pour la manipulation de couches vierges, partiellement ou totalement processées.

L'invention concerne également un procédé de démontage de la structure démontable 100.

Ce procédé prévoit l'utilisation d'une structure démontable 100 selon l'un ou l'autre des modes de réalisation précédemment décrits.

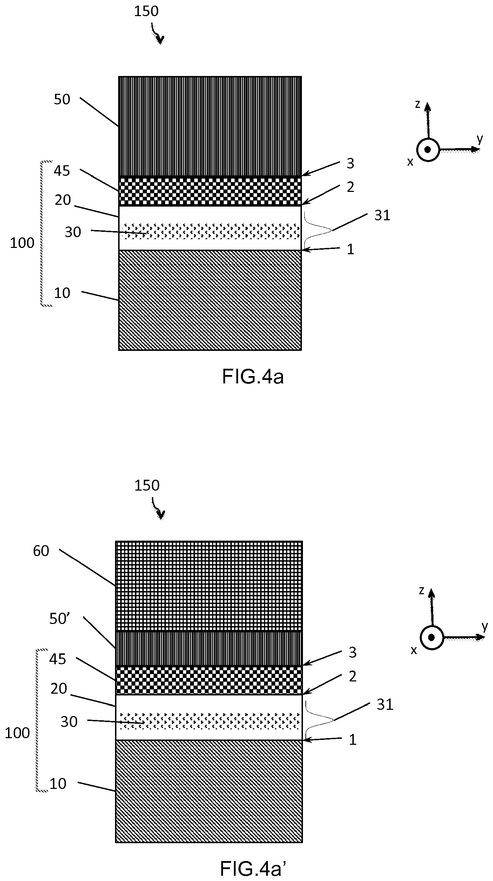

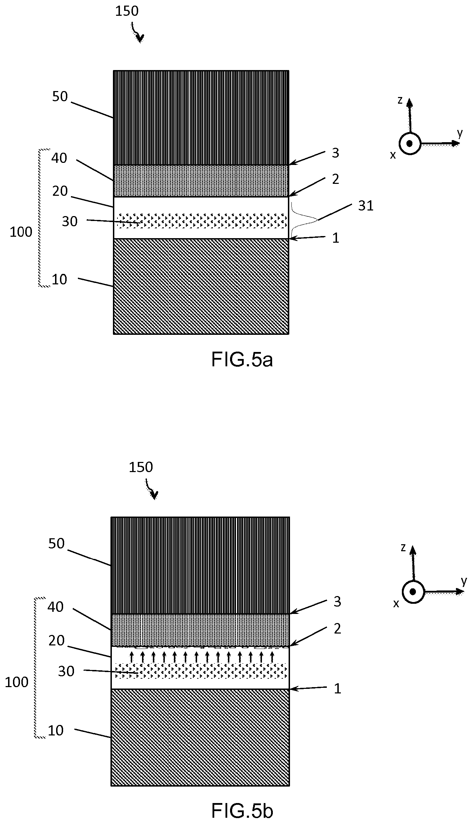

Le procédé de démontage comprend tout d'abord une étape a) d'assemblage de la structure démontable 100 et d'un deuxième substrat 50 le long d'une interface de collage 3 (figures 4a et 5a).

Selon une première variante de mise en œuvre, le deuxième substrat 50 est destiné d'une part, à être aminci pour former une couche utile 50', et d'autre part à être assemblé sur un troisième substrat 60 (figure 4a'). La structure démontable 100 remplit dans ce cas la fonction d'une poignée temporaire permettant la manipulation de la couche 50' au cours des étapes d'amincissement du deuxième substrat 50 et d'assemblage sur le troisième substrat 60. Une structure démontable 100 selon le premier ou le troisième mode de réalisation précédemment décrits, sera particulièrement adaptée à une telle application de poignée temporaire.

Selon une deuxième variante de mise en œuvre (figure 5a), le deuxième substrat 50 présente des caractéristiques spécifiques et il est destiné à recevoir la couche mince 40 adaptée à la fabrication de composants (c'est-à-dire finie et présentant la qualité requise), pour ultérieurement subir des étapes de fabrication de composants, pour une application spécifique. La structure démontable 100 selon le deuxième mode de réalisation précédemment décrit, permet dans ce cas le transfert de la couche mince 40 du substrat support initial 10, compatible avec les étapes de finition de ladite couche mince 40, vers un deuxième substrat spécifique 50.

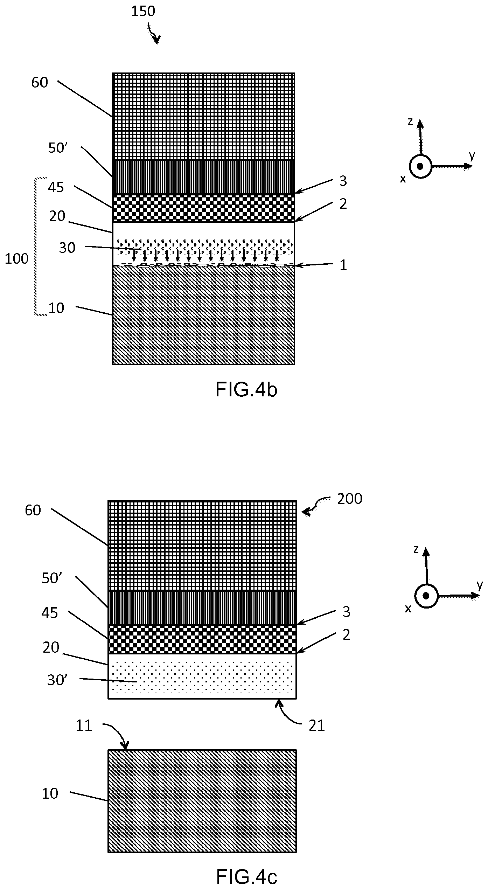

Le procédé de démontage selon l'invention comprend ensuite une étape b) au cours de laquelle un traitement thermique est appliqué à l'assemblage 150 pour faire migrer au moins une partie des espèces légères 30 au niveau de l'une des première 1 et deuxième 2 interfaces (au niveau de la première interface 1, illustré à titre d'exemple sur les figures 4b et 5b) .

Avantageusement, l'étape b) est effectuée à une température comprise entre 200°C et 600°C.

La couche d'oxyde 20 étant de faible épaisseur et la concentration des espèces légères 30 excédant très largement la limite de solubilité de cette même espèce dans la couche d'oxyde 20 (d'un facteur cinq à vingt) les espèces légères 30 ne pourront pas être absorbées en totalité par la couche d'oxyde 20 et une partie des espèces légères 30 va efficacement migrer vers les première 1 et deuxième 2 interfaces. Si la première interface 1 (ou alternativement la deuxième interface 2) est une interface thermique c'est-à-dire issue de la croissance d'une couche d'oxyde thermique sur le substrat support 10 en silicium (ou alternativement sur le substrat donneur 4), elle va préférentiellement attirer et piéger des espèces légères 30. La concentration croissante d'espèces légères 30 au niveau de cette interface va produire une décohésion de l'interface sous l'effet de la pression des espèces légères 30.

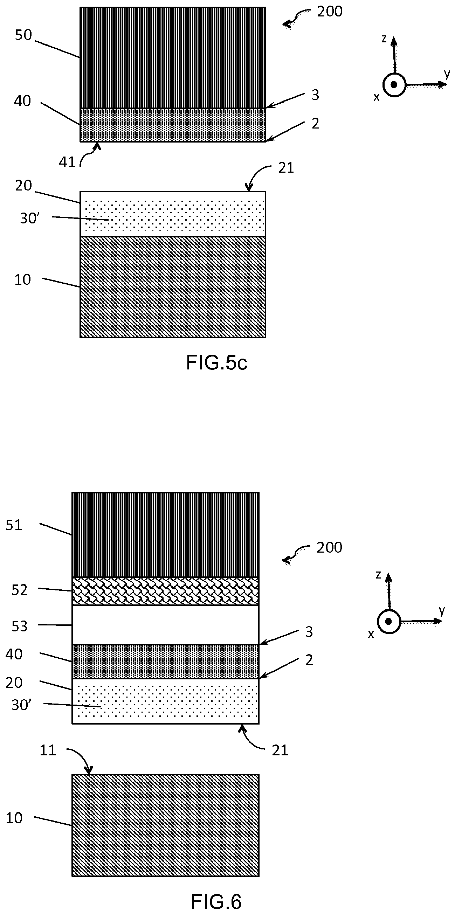

Le procédé de démontage selon l'invention comprend enfin une étape c) de détachement spontané de l'assemblage 150 au niveau de la première interface 1 (figure 4c), donnant lieu à une surface démontée 21 de la couche d'oxyde 20 reportée sur une structure composite 200 et à une surface démontée 11 du substrat support 10. Alternativement, le détachement s'opère au niveau de la deuxième interface 2 (figure 5c), donnant lieu à une surface démontée 21 de la couche d'oxyde 20 laquelle demeure sur la substrat support 10, et à une surface démontée 41 de la couche mince 40.

Par détachement spontané, on entend un détachement ne nécessitant pas de sollicitation mécanique ou chimique extérieure. C'est la décohésion de la première 1 ou de la deuxième 2 interface par la concentration des espèces légères 30 et la pression des espèces gazeuses formées à partir des espèces légères 30 qui induit le détachement, sur toute l'étendue de la structure démontable 100.

Ce détachement spontané s'effectue avantageusement au cours du traitement thermique de l'étape b).

A l'issue du détachement, on obtient d'une part, une structure composite 200 comprenant la couche utile 50' ou la couche mince 40, selon les modes de réalisation, et d'autre part, le substrat support 10 de la structure démontable 100 (figures 4c et 5c). La couche d'oxyde 20, selon que l'interface de démontage est la première 1 ou la deuxième 1 interface, se trouve dans la structure composite 200 ou sur le substrat support 10.

Le procédé de détachement selon l'invention permet l'obtention d'une rugosité de la surface démontée 21 de la couche d'oxyde 20, inférieure à 0,5nm. Cette caractéristique est favorisée par le fait qu'aucun endommagement de la première interface 1 (ou de la deuxième interface 2) n'est fait au cours de l'introduction des espèces légères 30, puisque le maximum de concentration du profil d'implantation reste toujours, selon l'invention, localisé à l'intérieur de la couche d'oxyde 20. L'interface de démontage est particulièrement lisse, notamment dans le cas d'une interface thermique. Le détachement le long de cette interface induit donc une très faible rugosité des surfaces démontées 21,11,41, correspondant à la rugosité de l'interface avant détachement. Cela permet de limiter les traitements à appliquer sur l'une ou l'autre des surfaces démontées 21,11,41 pour respectivement faire la finition de la structure composite 200 et recycler pour réutilisation le substrat support 10.

Avantageusement, le procédé de démontage selon l'invention comprend, après l'étape c), une étape de traitement thermique de la structure composite 200 à une température inférieure à 1000°C, pour évacuer les espèces légères résiduelles 30' encore présentes dans les couches transférées 20,40 (figures 4c et 5c).

Dans certains cas, la couche d'oxyde 20 et potentiellement la couche mince barrière 45 sont éliminées pour donner accès à la couche sous-jacente, par exemple la couche utile 50' (figure 4c).

Dans un exemple de la deuxième variante de mise en œuvre du procédé de démontage selon l'invention, le deuxième substrat 50 fourni à l'étape a) comprend un substrat support 51 (appelé par la suite deuxième substrat support 51), une couche de piégeage 52 disposée sur le deuxième substrat support 51 et une couche d'oxyde de silicium 53 (appelée par la suite deuxième couche d'oxyde 53) disposée sur la couche de piégeage 52. Lors de l'étape a) d'assemblage, la deuxième couche d'oxyde 53 est assemblée sur le substrat démontable 100 au niveau de l'interface de collage 3.

Comme illustré sur la figure 6, à l'issue de l'étape c) du procédé de démontage, on obtient une structure composite 200 comprenant une couche mince 40, adaptée à la fabrication de composants et disposée sur un substrat spécifique comportant une couche de piégeage 52 et une deuxième couche d'oxyde 53, ce dernier formant l'oxyde enterré de la structure composite 200.

Des étapes de finition à basse température peuvent ensuite être appliquées comme notamment un traitement thermique à une température inférieure ou égale à 1000°C pour évacuer le résidu d'espèces légères 30' présent dans la couche mince 40 et dans la couche d'oxyde 20 (si elle est présente) . Enfin, un traitement chimique de retrait de la couche d'oxyde 20 et un nettoyage de la structure composite 200 peuvent être appliqués pour obtenir un substrat de type SOI, avec une couche mince 40 de haute qualité et un substrat spécifique adapté en particulier aux applications radiofréquences. La couche mince 40 peut présenter une épaisseur inférieure à 100nm, voire inférieure à 50nm, voire encore inférieure à 25nm. Des couches présentant de telles épaisseurs et une haute qualité (en particulier uniformité meilleure que +/- 1 nm, très faible défectivité, faible rugosité de surface < 0,2nm) sont extrêmement complexes à fabriquer sur un substrat spécifique comportant une couche de piégeage 52, notamment du fait de la restriction en température des traitements de finition, pour éviter l'endommagement de ladite couche de piégeage 52.

La structure démontable 100 et le procédé de démontage selon l'invention permettent l'obtention aisée d'une structure composite 200 avec une couche mince 40 de haute qualité, quelle que soit son épaisseur.

Dans un autre exemple de la deuxième variante de mise en œuvre du procédé de démontage, le deuxième substrat 50 fourni à l'étape a) comprend un substrat en verre.

A l'issue de l'étape c) du procédé de démontage, on obtient ainsi une structure composite 200 comprenant une couche mince 40, adaptée à la fabrication de composants et disposée sur un substrat spécifique en verre.

Une couche mince présentant une haute qualité est extrêmement complexe à fabriquer sur un substrat spécifique, de nature hétérogène vis-à-vis de ladite couche mince 40, notamment du fait de la restriction en température des traitements de finition, pour éviter l'endommagement de la couche mince et/ou de l'hétéro-structure elle-même du fait des dilatations différentielles des matériaux formant ladite hétéro-structure. La structure démontable 100 et le procédé de démontage selon l'invention permettent l'obtention aisée d'une structure composite 200 hétérogène avec une couche mince 40 de haute qualité transférée sur un substrat de verre.

Dans encore un autre exemple de la deuxième variante de mise en œuvre du procédé de démontage selon l'invention, le deuxième substrat 50 fourni à l'étape a) comprend un deuxième substrat support (en silicium ou autre matériau d'intérêt pour l'application visée) et une deuxième couche d'oxyde de silicium disposée sur le deuxième substrat support et présentant une épaisseur supérieure à 800nm, la deuxième couche d'oxyde de silicium étant destinée à être assemblée sur le substrat démontable au niveau de l'interface de collage 3.

A l'issue de l'étape c) du procédé de démontage, on obtient ainsi une structure composite 200 comprenant une couche mince 40, adaptée à la fabrication de composants et disposée sur un substrat spécifique muni d'une deuxième couche d'oxyde épais.

Une couche mince 40 de haute qualité est en général complexe à fabriquer sur un substrat spécifique comportant une couche d'oxyde épais. Par exemple, l'obtention de couches fines de silicium (<100nm) sur des oxydes épais (>400nm) est complexe du fait du faible module élastique de l'oxyde. En effet, toute sollicitation mécanique (polissage, fracture) de la fine couche de silicium risque de conduire à sa rupture à cause de la déformation de l'oxyde épais sous-jacent.

La structure démontable 100 et le procédé de démontage selon l'invention permettent l'obtention aisée d'une structure composite 200 hétérogène avec une couche mince 40 de haute qualité reportée sur une couche d'oxyde épais.

Bien sur, l'invention n'est pas limitée aux modes de réalisation décrits et on peut y apporter des variantes de réalisation sans sortir du cadre de l'invention tel que défini par les revendications.

## Revendications

1. Structure démontable (100) comportant un substrat support (10) et une couche d'oxyde de silicium (20) disposée sur ledit substrat (10) au niveau d'une première interface (1), la structure démontable (100) étant **caractérisée en ce que** :
• La couche d'oxyde (20) présente une épaisseur inférieure à 200 nm ;
• Des espèces légères (30) d'hydrogène et/ou d'hélium sont réparties en profondeur et sur toute l'étendue de la structure (100) selon un profil d'implantation (31) dont le maximum de concentration est situé dans l'épaisseur de la couche d'oxyde (20) ;
• La dose totale d'espèces légères (30) implantées, ramenée à l'épaisseur de la couche d'oxyde (20), excède au moins d'un facteur cinq la limite de solubilité de ces espèces légères (30) dans ladite couche d'oxyde (20).

2. Structure démontable (100) selon la revendication précédente, comprenant une couche mince adaptée pour la fabrication de composants (40) et/ou formant une couche barrière (45), disposée sur la couche d'oxyde (20) au niveau d'une deuxième interface (2).

3. Structure démontable (100) selon la revendication précédente, dans laquelle le substrat support (10) est en silicium et la couche d'oxyde de silicium (20) est un oxyde thermique.

4. Structure démontable (100) selon la revendication précédente, dans laquelle la couche mince (40) adaptée pour la fabrication de composants est en silicium monocristallin.

5. Structure démontable (100) selon la revendication 3, dans laquelle la couche mince (45) formant une couche barrière est en nitrure de silicium.

6. Procédé de démontage de la structure démontable (100) selon la revendication 2, comprenant :
a) L'assemblage de la structure démontable (100) et d'un deuxième substrat (50) le long d'une interface de collage (3) ;
b) L'application d'un traitement thermique à l'assemblage (150) pour faire migrer au moins une partie des espèces légères (30) au niveau de la première (1) ou de la deuxième (2) interface ;
c) Le détachement spontané de l'assemblage (150) au niveau de la première interface (1) ou de la deuxième interface (2), formant une surface démontée (21) de la couche d'oxyde (20) et menant au transfert d'au moins la couche mince (40,45) sur le deuxième substrat (50) pour former une structure composite (200).

7. Procédé de démontage selon la revendication précédente, dans lequel l'étape b) est effectuée à une température comprise entre 200°C et 600°C.

8. Procédé de démontage selon l'une des deux revendications précédentes, dans lequel l'étape c) s'effectue au cours du traitement thermique de l'étape b).

9. Procédé de démontage selon l'une des trois revendications précédentes, dans lequel la rugosité de la surface démontée (21) de la couche d'oxyde (20) est inférieure à 0,5nm RMS.

10. Procédé de démontage selon l'une des quatre revendications précédentes, dans lequel la structure démontable (100) fournie à l'étape a), comprend une couche mince (40) adaptée pour la fabrication de composants, disposée sur la couche d'oxyde (20), au niveau de la deuxième interface (2) et dans lequel les espèces légères (30) d'hydrogène et/ou d'hélium ont été implantées dans l'épaisseur de la couche d'oxyde (20) après une étape de finition de la couche mince (40).

11. Procédé de démontage selon la revendication précédente, dans lequel l'étape de finition de la couche mince (40) comprend un traitement thermique à haute température, en particulier supérieure à 1000°C, voire supérieure à 1100°C.

12. Procédé de démontage selon l'une des deux revendications précédentes, dans lequel le deuxième substrat (50) fourni à l'étape a) comprend un deuxième substrat support (51), une couche de piégeage (52) disposée sur le deuxième substrat support (51) et une deuxième couche d'oxyde de silicium (53) disposée sur la couche de piégeage (52), la deuxième couche d'oxyde (53) étant destinée à être assemblée sur le substrat démontable (100) au niveau de l'interface de collage (3).

13. Procédé de démontage selon l'une des revendications 10 et 11, dans lequel le deuxième substrat (50) fourni à l'étape a) comprend un substrat en verre.

14. Procédé de démontage selon l'une des revendications 10 et 11, dans lequel le deuxième substrat (50) fourni à l'étape a) comprend un deuxième substrat support et une deuxième couche d'oxyde de silicium disposée sur le deuxième substrat support et présentant une épaisseur supérieure à 800nm, la deuxième couche d'oxyde de silicium étant destinée à être assemblée sur le substrat démontable (100) au niveau de l'interface de collage (3).

15. Procédé de démontage selon l'une des cinq revendications précédentes, comprenant, après l'étape c), une étape de traitement thermique de la structure composite (200) à une température inférieure à 1000°C, pour évacuer les espèces légères encore présentes dans la couche mince transférée.

## Patentansprüche

1. Entfernbare Struktur (100) mit einem Trägersubstrat (10) und einer Siliziumoxidschicht (20), die auf dem Substrat (10) an einer ersten Grenzfläche (1) angeordnet ist, wobei die entfernbare Struktur (100) durch Folgendes gekennzeichnet ist:
• Die Oxidschicht (20) hat eine Dicke von weniger als 200 nm;
• Leichte Wasserstoff- und/oder Heliumspezies (30) sind in der Tiefe und über die gesamte Struktur (100) gemäß einem Implantationsprofil (31) verteilt, dessen Konzentrationsmaximum innerhalb der Dicke der Oxidschicht (20) liegt;
• Die Gesamtdosis der implantierten leichten Spezies (30), bezogen auf die Dicke der Oxidschicht (20), überschreitet die Löslichkeitsgrenze dieser leichten Spezies (30) in der Oxidschicht (20) um mindestens einen Faktor fünf.

2. Entfernbare Struktur (100) nach dem vorstehenden Anspruch, umfassend eine Dünnschicht, die für die Herstellung von Komponenten (40) geeignet ist und/oder eine Sperrschicht (45) bildet, die auf der Oxidschicht (20) an einer zweiten Grenzfläche (2) angeordnet ist.

3. Entfernbare Struktur (100) nach dem vorstehenden Anspruch, wobei das Trägersubstrat (10) aus Silizium besteht und die Siliziumoxidschicht (20) ein thermisches Oxid ist.

4. Entfernbare Struktur (100) nach dem vorstehenden Anspruch, wobei die Dünnschicht (40), die für die Herstellung von Komponenten geeignet ist, aus monokristallinem Silizium besteht.

5. Entfernbare Struktur (100) nach Anspruch 3, wobei die Dünnschicht (45), die eine Barriereschicht bildet, aus Siliziumnitrid besteht.

6. Verfahren zum Entfernen der entfernbaren Struktur (100) nach Anspruch 2, umfassend:
a) die Verbindung der entfernbaren Struktur (100) und eines zweiten Substrats (50) entlang einer Klebegrenzfläche (3);
b) die Durchführung einer Wärmebehandlung an der Verbindung (150), um mindestens einen Teil der leichten Spezies (30) an der ersten (1) oder zweiten (2) Grenzfläche zum Migrieren zu veranlassen;
c) die spontane Ablösung der Verbindung (150) an der ersten Grenzfläche (1) oder der zweiten Grenzfläche (2), die eine von der Oxidschicht (20) entfernte Oberfläche (21) bildet und zur Übertragung von mindestens der Dünnschicht (40, 45) auf das zweite Substrat (50) führt, um eine Verbundstruktur (200) zu bilden.

7. Entfernungsverfahren nach dem vorstehenden Anspruch, wobei Schritt b) bei einer Temperatur zwischen 200 °C und 600 °C durchgeführt wird.

8. Entfernungsverfahren nach einem der beiden vorstehenden Ansprüche, wobei Schritt c) während der Wärmebehandlung in Schritt b) durchgeführt wird.

9. Entfernungsverfahren nach einem der drei vorstehenden Ansprüche, wobei die Rauheit der entfernten Oberfläche (21) der Oxidschicht (20) weniger als 0,5 nm RMS beträgt.

10. Entfernungsverfahren nach einem der vier vorstehenden Ansprüche, wobei die in Schritt a) erzeugte entfernbare Struktur (100) eine Dünnschicht (40) umfasst, die für die Herstellung von Komponenten geeignet ist und auf der Oxidschicht (20) an der zweiten Grenzfläche (2) angeordnet ist, und wobei die leichten Wasserstoff- und/oder Heliumspezies (30) nach einem Schritt der Endbearbeitung der Dünnschicht (40) in die Dicke der Oxidschicht (20) implantiert worden sind.

11. Entfernungsverfahren nach dem vorstehenden Anspruch, wobei der Schritt der Endbearbeitung der Dünnschicht (40) eine Wärmebehandlung bei hoher Temperatur, insbesondere höher als 1000°C oder sogar höher als 1100°C, umfasst.

12. Entfernungsverfahren nach einem der beiden vorstehenden Ansprüche, wobei das in Schritt a) erzeugte zweite Substrat (50) ein zweites Trägersubstrat (51), eine auf dem zweiten Trägersubstrat (51) angeordnete Fangschicht (52) und eine auf der Fangschicht (52) angeordnete zweite Siliziumoxidschicht (53) umfasst, wobei die zweite Oxidschicht (53) dazu bestimmt ist, an der Klebegrenzfläche (3) auf dem entfernbaren Substrat (100) verbunden zu werden.

13. Entfernungsverfahren nach einem der Ansprüche 10 oder 11, wobei das in Schritt a) erzeugte zweite Substrat (50) ein Glassubstrat umfasst.

14. Entfernungsverfahren nach einem der Ansprüche 10 und 11, wobei das in Schritt a) erzeugte zweite Substrat (50) ein zweites Trägersubstrat und eine auf dem zweiten Trägersubstrat angeordnete zweite Siliziumoxidschicht mit einer Dicke von über 800 nm umfasst, wobei die zweite Siliziumoxidschicht dazu bestimmt ist, an der Klebegrenzfläche (3) auf dem entfernbaren Substrat (100) verbunden zu werden.

15. Entfernungsverfahren nach einem der fünf vorstehenden Ansprüche, umfassend, nach Schritt c), einen Schritt der Wärmebehandlung der Verbundstruktur (200) bei einer Temperatur von unter 1000°C, um die in der übertragenen Dünnschicht noch vorhandenen leichten Spezies zu eliminieren.

## Claims

1. Removable structure (100) comprising a support substrate (10) and a silicon oxide layer (20) arranged on said substrate (10) at a first interface (1), the removable structure (100) being **characterised in that**:
• The oxide layer (20) has a thickness of less than 200nm;
• Light hydrogen and/or helium species (30) are deeply distributed and over the whole extent of the structure (100) according to an implantation profile (31), the maximum concentration of which is located in the thickness of the oxide layer (20);
• The total dose of implanted light species (30), with respect to the thickness of the oxide layer (20), exceeds the solubility limit of these light species (30) in said oxide layer (20) by at least a factor of five.

2. Removable structure (100) according to the preceding claim, comprising a thin layer adapted for the manufacture of components (40) and/or forming a barrier layer (45), arranged on the oxide layer (20) at a second interface (2).

3. Removable structure (100) according to the preceding claim, wherein the support substrate (10) is made of silicon and the silicon oxide layer (20) is a thermal oxide.

4. Removable structure (100) according to the preceding claim, wherein the thin layer (40) adapted for the manufacture of components is made of monocrystalline silicon.

5. Removable structure (100) according to claim 3, wherein the thin layer (45) forming a barrier layer is made of silicon nitride.

6. Method for removing the removable structure (100) according to claim 2, comprising:
a) The assembly of the removable structure (100) and of a second substrate (50) along a bonding interface (3);
b) The application of a heat treatment to the assembly (150) to make at least some of the light species (30) migrate to the first (1) or the second (2) interface;
c) The spontaneous detachment of the assembly (150) at the first interface (1) or at the second interface (2), forming a removed surface (21) of the oxide layer (20) and leading to the transfer of at least the thin layer (40, 45) on the second substrate (50) to form a composite structure (200).

7. Removal method according to the preceding claim, wherein step b) is carried out at a temperature of between 200°C and 600°C.

8. Removal method according to one of the two preceding claims, wherein step c) is carried out during the heat treatment of step b).

9. Removal method according to one of the three preceding claims, wherein the roughness of the removed surface (21) of the oxide layer (20) is less than 0.5nm RMS.

10. Removal method according to one of the four preceding claims, wherein the removable structure (100) provided in step a), comprising a thin layer (40) adapted for the manufacture of components, arranged on the oxide layer (20), at the second interface (2) and wherein the light hydrogen and/or helium species (30) have been implanted in the thickness of the oxide layer (20) after a finishing step of the thin layer (40).

11. Removal method according to the preceding claim, wherein the finishing step of the thin layer (40) comprises a high-temperature heat treatment, in particular greater than 1000°C, even greater than 1100°C.

12. Removal method according to one of the two preceding claims, wherein the second substrate (50) provided in step a) comprises a second support substrate (51), a sequestration layer (52) arranged on the second support substrate (51) and a second silicon oxide layer (53) arranged on the sequestration layer (52), the second oxide layer (53) being intended to be assembled on the removable substrate (100) at the bonding interface (3).

13. Removal method according to one of claims 10 and 11, wherein the second substrate (50) provided in step a) comprises a glass substrate.

14. Removal method according to one of claims 10 and 11, wherein the second substrate (50) provided in step a) comprises a second support substrate and a second silicon oxide layer arranged on the second support substrate and having a thickness of greater than 800nm, the second silicon oxide layer being intended to be assembled on the removable substrate (100) at the bonding interface (3).

15. Removal method according to one of the five preceding claims, comprising, after step c), a step of heat treating the composite structure (200) at a temperature of less than 1000°C, to discharge the light species still present in the transferred thin layer.
